# EUROPÄISCHE PATENTSCHRIFT

(11) **EP 0 313 739 B1**
(45) Veröffentlichungstag und Bekanntmachung des Hinweises auf die Patenterteilung: **13.01.1993**
(21) Anmeldenummer: 88112284.0
(22) Anmeldetag: 29.07.1988
(51) Int. Cl.: H05K 9/00, B60K 37/02

(54) **Kombinationsinstrument für Kraftfahrzeuge**
Combined instruments for vehicle
Instruments combinés pour automobile

(30) Priorität: 30.10.1987 DE 3736761; 12.01.1988 DE 3800572
(43) Veröffentlichungstag der Anmeldung: 03.05.1989
(73) Patentinhaber: VDO Adolf Schindling AG, D-60487 Frankfurt (DE)
(72) Erfinder: Fleischer, Helmut, D-6361 Niddatal (DE); Simon, Ernst-Ulrich, D-6370 Oberursel/Ts. (DE); Schmitt, Günter, D-6233 Kelkheim (DE)

(56) Entgegenhaltungen:
- DE-A- 3 515 910
- DE-U- 1 966 739
- FR-A- 2 506 009
- GB-A- 2 119 729
- ELECTRONIC COMPONENTS AND APPLICATIONS. vol. 6, no. 4, 1984, EINDHOVEN NL Seiten 202 - 208; E. LOWAERD AND P. STEIT: "LIQUID-CRYSTAL DISPLAYS FOR AUTOMOTIVE APPLICATIONS"

## Beschreibung

Die Erfindung bezieht sich auf ein Kombinationsinstrument für Kraftfahrzeuge, bei dem verschiedene Anzeigeinstrumente, Anzeigefelder, Kontroll- und Warnleuchten und gegebenenfalls Bedienteile sowie elektrische und elektronische Ausrüstungsteile in einem gemeinsamen Gehäuse angeordnet und durch eine gemeinsame Sichtscheibe abgedeckt sind.

Derartige Kombinationsinstrumente sind seit langem bekannt (siehe z.B. GB-A-2119729) und werden an Stelle der früher üblichen Einzelinstrumente zur Kontrolle verschiedener Funktionen eines Kraftfahrzeuges eingesetzt. Sie enthalten dazu je nach Ausstattungsgrad z.B. den Geschwindigkeitsmesser (Tachometer), Wegstreckenzähler, Drehzahlmesser, Kraftstoffvorratsanzeige, Kühlwassertemperaturanzeige, Zeituhr, Kontrolleuchten für Öldruck, Generator, Fernlicht, Fahrrichtungsanzeiger, und anderes mehr, wie z.B. Überwachungs- und Rechnersysteme mit deren Anzeigesystemen und sind im Kraftfahrzeug jeweils im Blickfeld des Fahrers in einem entsprechend geformten Instrumententräger untergebracht, der wiederum an der Karosserie befestigt ist.

In zunehmendem Maße werden elektrisch gesteuerte Anzeigen in solchen Kombinationsinstrumenten verwendet, die neben der größeren Gestaltungsfreiheit eine intelligentere Ansteuerung und damit genauere oder sinnfälligere Anzeigen ermöglichen. Die Ansteuerung erfolgt im allgemeinen unter Verwendung von Mikroprozessoren oder hochintegrierten, anwendungsspezifischen Schaltkreisen. Die darin verarbeiteten digitalen Impulsfolgen sind sehr steilflankig und teilweise auch höherfrequent. Infolgedessen sind sie die Ursache für radiofrequente Störungen, die beim Betrieb des Kraftfahrzeuges evtl. vorhandene weitere elektronische Systeme beeinflussen oder den Rundfunkempfang oder Funkverkehr erschweren. Gleichzeitig sind diese Impulsfolgen aber auch empfindlich gegen Störungen von außen. Solche Störungen können aus anderen elektronischen Systemen, der Hochspannungs-Zündanlage, auch fremder Fahrzeuge, herrühren oder von starken Rundfunk- oder Fernsehsendern im Nahbereich.

Grundsätzlich besteht weiter ein ständiges Interesse daran, daß Ausrüstungen für Kraftfahrzeuge wenig Raum einnehmen, um das Platzangebot für die Insassen zu verbessern.

Die Erfindung liegt demgemäß die Aufgabe zugrunde, ein Kombinationsinstrument nach dem Gattungsbegriff so weiterzubilden, daß sowohl die Auswirkungen eingehender leitungsgebundener und nicht leitungsgebundener Störungen unterdrückt als auch die drahtlose Ausbreitung ausgehender radiofrequenter Impulsreihen vermindert werden. Gleichzeitig soll die Einbautiefe verringert werden.

Die Lösung dieser Aufgabe erfolgt mit den im kennzeichnenden Teil des Hauptanspruchs angegebenen Maßnahmen. Dabei ist vorteilhaft, daß sich die erfindungsgemäßen Maßnhamen nur auf einen Teil des Kombinationsinstruments erstrecken. Weiter ist vorteilhaft, daß der bisherige Aufbau eines Kombinationsinstruments nicht grundsätzlich geändert werden muß.

Vorteilhafte Ausgestaltungen und Weiterbildungen des erfindungsgemäßen Kombinationsinstruments ergeben sich aus den Unteransprüchen.

Unter anderem ist vorteilhaft, daß durch die einstückige Ausbildung der von der Leiterplatte in das Steckergehäuse ragenden Kontaktstifte in Einbauhöhe gering gehalten werden kann. Dadurch entfallen die Verbindungen von der Leiterplatte zu gesondert im Steckerunterteil befestigten Kontaktstiften. Somit ist das erfindungsgemäße Kombinationsinstrument insgesamt zuverlässiger.

Es ist zwar ein hochfrequenzdichtes Gehäuse mit Anschlußstutzen bekannt (DE-OS 35 15 910), dabei handelt es sich jedoch um einen Abzweiger oder Verteiler für Kabelfernsehanlagen mit einem Netz aus Koaxialkabeln.

Ein Ausführungsbeispiel der Erfindung ist in der Zeichnung dargestellt und in der nachfolgenden Beschreibung näher erläutert.

Es zeigen:
- Figur 1: das Kombinationsinstrument in Frontsicht
- Figur 2: das gleiche Kombinationsinstrument in auseinandergezogener, perspektivischer Darstellung ohne Frontblende,
- Figur 3: in Schnittdarstellung ein Gehäuse zur Aufnahme elektronischer Schaltkreise
- Figur 4: ebenfalls in Schnittdarstellung ein anderes Gehäuse zur Aufnahme elektronischer Schaltkreise.

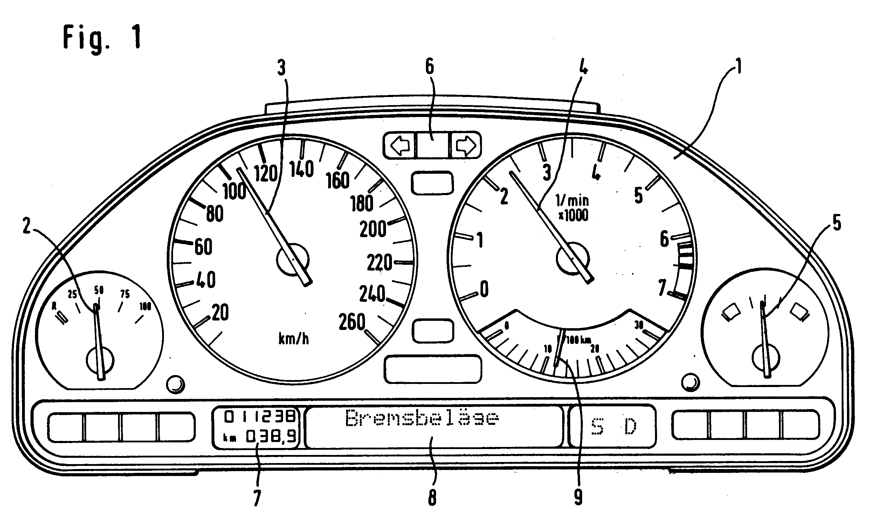

In Figur 1 ist mit 1 die Frontblende eines Kombinationsinstruments bezeichnet, das nebeneinander in wesentlich der gleichen Ebene eine Tankvorratsanzeige 2, einen Geschwindigkeitsmesser 3, einen Motordrehzahlmesser 4 mit integrierter Verbrauchsanzeige 9 und eine Kühlwasseranzeige 5 aufweist, ferner eine Kontrolleuchte für den Fahrtrichtungsanzeiger 6 sowie eine Flüssigkristallanzeige 7 für elektronische Kilometerzähler und eine Punktmatrix-Anzeige 8 für verschiedene Warnfunktionen.

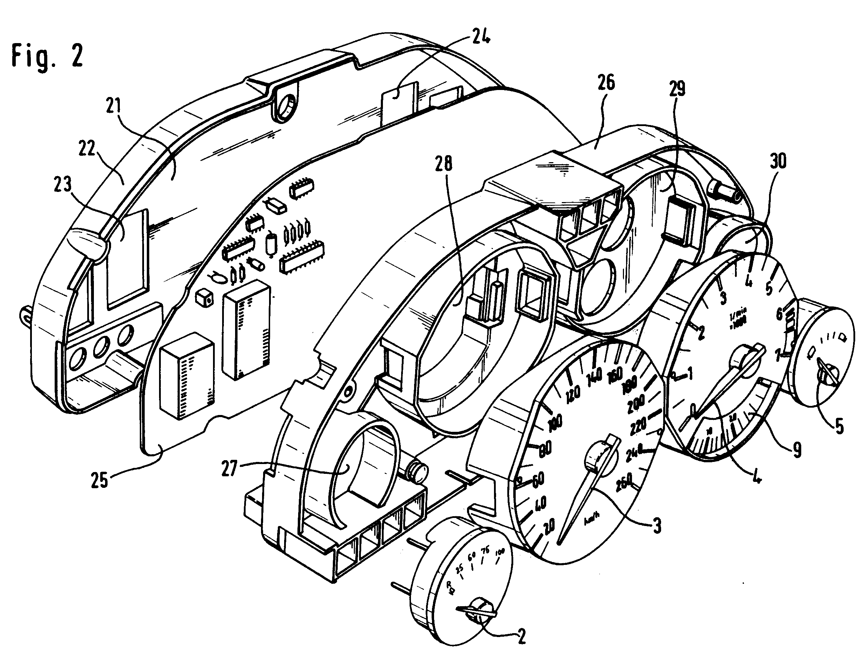

Figur 2 zeigt den Aufbau des Kombinationsinstruments. Es besteht aus einer Rückwand 21 mit angeformtem Rand 22. In der Rückwand sind eine Anzahl von Durchbrüchen 23, 24 zur Aufnahme von Steckverbindungen angeordnet, die zur elektrischen Verbindung des Kombinationsinstruments mit den zugehörigen Sensoren und Fremdschaltkreisen, wie z.B. dem Schaltkreis zur Aktivierung der Fahrrichtungsanzeiger, vorgesehen ist.

In die Rückwand 21 ist eine Leiterplatte 25 einlegbar, die alle für die Funktion des Kombinationsinstruments erforderlichen aktiven und passiven Schaltelemente, Leiterbahnen, Steckverbinder und Anschlußpunkte enthält. Die Leiterplatte 25 trägt ferner die für die Signalverarbeitung erforderliche Rechnereinheit, die z.B. aus zwei Einzel-Chip-Mikrorechnern und anwendungsspezifischen integrierten Schaltkreisen bestehen kann. Diese Rechnereinheit ist in später noch näher beschriebenen Weise auf der Leiterplatte 25 angeordnet.

Vor der Leiterplatte 25 ist eine Trägerplatine 26 angeordnet, die ebenso wie die Rückwand 21 aus einem thermoplastischen Kunststoff geeigneter Zusammensetzung im Spritzgießverfahren hergestellt sein kann. Sie bestimmt zusammen mit dem Rand 22 der Rückwand 21 die äußere Gestalt des Kombinationsinstruments und weist eine Anzahl von Durchbrüchen 27, 28, 29, 30 zur Aufnahme der elektro-mechanischen Anzeigesysteme für die Analoganzeigen 2 bis 5 und 9 auf. Diese Anzeigesysteme lassen sich als Komponenten des Kombinationsinstruments je nach Ausstattungsvariante des Fahrzeugs in bestimmtem Umfang austauschen und entsprechend mit der Leiterplatte 25 verbinden. So kann an Stelle des Motordrehzahlmessers 4 mit integrierter Tankanzeige 9 eine Zeituhr eingebaut und betrieben werden. Ebenso lassen sich elektrooptische Displays für die angegebenen Anzeigefunktionen bei entsprechender Gestaltung und Auslegung der verwendeten Komponenten des Kombinationsinstruments verwenden.

Wie bereits eingangs erwähnt, erfordert der Einsatz einer hochintegrierten Elektronik in einem Kombinationsinstrument eines Kraftfahrzeugs besondere Maßnahmen zur Störungsunterdrückung in beiden Richtungen. Dabei soll sowohl die Rechnereinheit vor Störungen von außen als auch die übrige Fahrzeugelektronik vor Störungen durch den Instrumentenrechner geschützt werden.

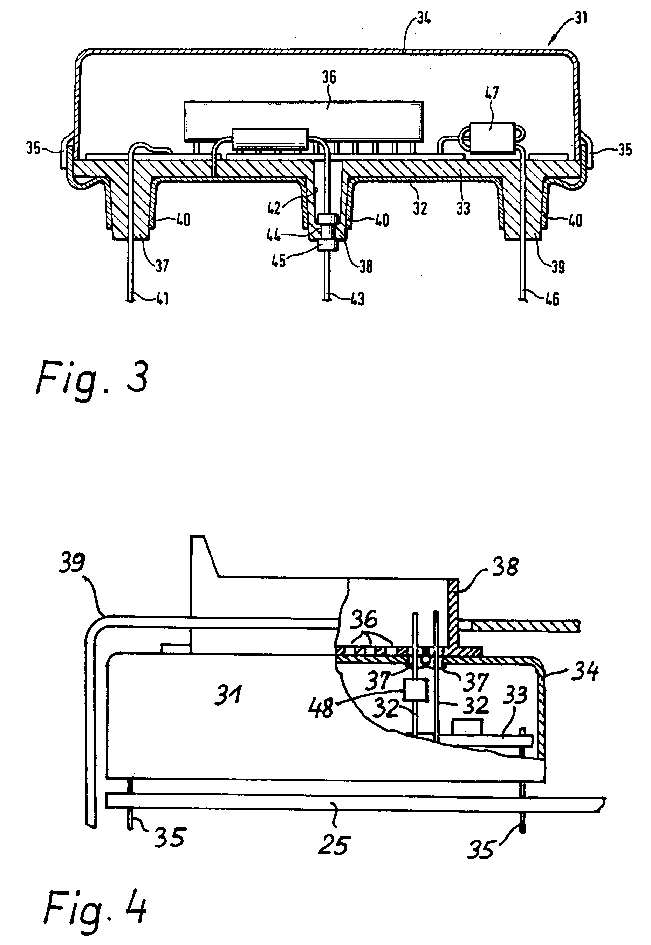

Auf der Leiterplatte 25 (Figur 2) ist daher entsprechend Figur 3 ein Abschirmgehäuse 31 zur Aufnahme der Rechnereinheit und der Peripherie-Beschaltung befestigt. Das Abschirmgehäuse 31 besteht aus dem Gehäuseunterteil 32, das als Halbschale zur Aufnahme einer Leiterplatte 33 oder eines Dickschichthybrids ausgebildet ist, und einem Gehäuseoberteil 34. Gehäuseunterteil 32 und Gehäuseoberteil 34 schließen die Leiterplatte 33 ein und sind an den verbindenden Rändern hochfrequenzdicht ausgebildet.

Dazu sind am Rand des Gehäuseoberteils federnde oder rastende verschränkte Laschen 35 vorgesehen, die in Abständen den Rand des Gehäuseunterteils übergreifen. Gehäuse-oberteil 34 und Gehäuseunterteil 32 können nach Fertigstellung der Baueinheit zur Verbesserung der Hochfrequenzdichtigkeit miteinander verlötet werden.

Die Rechnereinheit 36 im Abschirmgehäuse 31 muß zur Sicherstellung der Funktion über verschiedene Peripherieschaltungen oder auch direkt mit den Sensoren und Anzeigesystemen verbunden sein. Es hat sich gezeigt, daß eine vollständige Abschirmung der zu- und abführenden Leitungen in aller Regel nicht erforderlich ist, sondern daß es genügt, wenn die aus dem Abschirmgehäuse heraus- und hineinführenden Leitungen durch Filtermaßnahmen von hoch- und höchstfrequenten Störungen befreit werden. Die Leiterplatte 33 ist dazu mit Anschlußstutzen versehen, von denen jeder zur Durchführung einer Anschlußleitung bestimmt ist und von denen bei 37, 38, 39 eine Anzahl beispielhaft dargestellt ist. Das Gehäuseunterteil 32 ist im Bereich der Anschlußstutzen 37, 38, 39 aufgetütet, so daß jeder Anschlußstutzen bis in den Endbereich von einem Blechmantel 40 umgeben ist.

Der Blechmantel 40 als Teil des Gehäuseunterteils 32 bildet mit der durchgeführten Leitung 41 und dem Isolierstoff des Anschlußstutzens 37 einen Kondensator geringer Kapazität, die im übrigen von der Länge und dem Durchmesser des Blechmantels 40 sowie von der Dielektrizitätskonstanten des für den Anschlußstutzen 37 verwendeten Stoffes abhängt. Für schwach verseuchte Leitungen ist diese Filterung gegebenenfalls schon ausreichend.

Für stärker durch Störungen beeinflußte Leitungen wird eine Anordnung wie im Anschlußstutzen 38 vorgezogen. Hier weist der Anschlußstutzen 38 eine größere Bohrung auf, die zentrisch von der Leitung 43 durchquert wird. In der Abschlußwand 44 des Anschlußstutzens 38 ist ein Durchführungskondensator 45 befestigt, dessen Filterwirkung zweckmäßigerweise auf die Frequenz der häufigsten und schwerwiegendsten Störungen abgestimmt ist.

Nach einer weiteren Ausgestaltung ist die Leitung 46 unmittelbar nach dem Eintritt in das Abschirmgehäuse 31 mehrfach durch einen Ferritkern 47 geführt, um die Störungen auf der Leitung 46 zu unterdrücken. Diese Maßnahme kann nach Bedarf mit einer der beiden Filtermaßnahmen unter Bildung oder Verwendung eines Kondensators kombiniert sein. Ebenso kann es zweckmäßig sein, den Ferritkern an der Außenseite des Abschirmgehäuses unmittelbar am Anschlußstutzen 39 anzuordnen.

Bei einer weiteren Ausgestaltung der Erfindung soll die Einbautiefe nur um das unbedingt notwendige Maß vergrößert werden.

Auf der Leiterplatte 25 (Figur 2) ist daher entsprechend Fig. 4 ein Abschirmgehäuse 31 zur Aufnahme der Rechnereinheit und der Peripheriebeschaltung befestigt. Das Abschirmgehäuse 31 kann entsprechend der Ausführung im Hauptpatent aus einem Gehäuseunterteil, das als Halbschale zur Aufnahme einer Leiterplatte oder eines Hybridschaltkreises ausgebildet ist, und einem Gehäuseoberteil bestehen. In Fig. 4 ist der Boden des Abschirmgehäuses flach ausgebildet, über den das Gehäuseoberteil 34 greift und mit ihm hochfrequenzdicht nach einer der bekannten Techniken verbunden ist. Die Leiterplatte 33 ist einerseits über Kontaktstifte mechanisch und elektrisch mit den Anzeigesystemen auf der Leiterplatte 25 des Kombinationsinstruments verbunden, andererseits ragen Kontaktstifte 32 von der Leiterplatte 33 durch entsprechende Durchbrüche 36 des Gehäuseoberteils. Durchführungskondensatoren 37 in den Durchbrüchen 36 dienen zum Ausfiltern von Störungen auf den durch die Kontaktstifte 32 dargestellten Leitungen.

Die Kontaktstifte 32 münden in ein auf dem Gehäuseoberteil 34 befestigten Unterteil 38 einer aus zwei Teile bestehenden Steckverbindung. Dabei sind Material, Durchmesser und Länge der Kontaktstifte 32 so bemessen, daß sie die massiven Kontakte der Steckverbindung darstellen, über die die Buchsenkontakte des beweglichen Teils der Steckverbindung greifen und den elektrischen Kontakt herstellen.

Die Rückseite des Kombinationsinstruments einschließlich Leiterplatte 25 und Abschirmgehäuse 31 sind durch eine Abdeckung 39 geschützt, aus der bei dieser Ausführungsform nur das Unterteil 38 der Steckverbindung ragt. Dadurch wird die angestrebte geringe Einbautiefe erzielt und die Störstrahlungsfestigkeit verbessert.

Die Erfindung soll nicht auf die Anwendung in einem Kombinationsinstrument für Kraftfahrzeuge beschränkt sein. Es ist auch denkbar, andere elektronische Schaltkreise im Kraftfahrzeug gegen leitungsgebundene oder nicht leitungsgebundene Störungen in der angegebenen Weise zu schützen.

## Patentansprüche

1. Kombinationsinstrument für Kraftfahrzeuge, bei dem verschiedene Anzeigeinstrumente, Anzeigefelder, Kontroll- und Warnleuchten und gegebenenfalls Bedienteile sowie elektrische und elektronische Ausrüstungsteile in einem gemeinsamen Gehäuse angeordnet und durch eine gemeinsame Sichtscheibe abgedeckt sind, dadurch gekennzeichnet, daß ein Anzeigerechner (36) vorgesehen ist, der in einem weiteren im wesentlichen hochfrequenzdichten Gehäuse (31) angeordnet ist und daß das hochfrequenzdichte Gehäuse auf einer Leiterplatte (25) angeordnet ist.

2. Kombinationsinstrument nach Anspruch 2, dadurch gekennzeichnet, daß die Peripheriebeschaltung der Rechnereinheit (36) ebenfalls in dem hochfrequenzdichten Gehäuse (31) angeordnet ist.

3. Kombinationsinstrument nach Anspruch 1 oder 2, dadurch gekennzeichnet, daß zur Durchführung der Anschlußleitungen (41, 43, 46) an der Leiterplatte (33) für die Rechnereinheit (36) Anschlußstutzen (37, 38, 39) vorgesehen sind.

4. Kombinationsinstrument nach Anspruch 3, dadurch gekennzeichnet, daß der Gehäusemantel (32) des hochfrequenzdichten Gehäuses (31) zu jeweils einem die Anschlußstutzen (37, 38, 39) umschließenden Blechmantel 40 ausgeformt ist.

5. Kombinationsinstrument nach Anspruch 4, dadurch gekennzeichnet, daß Durchmesser und Länge des Blechmantels (40) sowie der Werkstoff des Anschlußstutzens (37) nach der zu erzielenden Kapazität des aus Blechmantel (40) und durchgeführter Leitung (41) gebildeten Kondensators ausgewählt sind.

6. Kombinationsinstrument nach einem der vorhergehenden Ansprüche, dadurch gekennzeichnet, daß die Leitung (43) mittels eines Durchführungskondensators (45) durch den Anschlußstutzen (38) geführt ist.

7. Kombinationsinstrument nach einem der Ansprüche 1 bis 6, dadurch gekennzeichnet, daß die Leitung (46) im unmittelbaren Bereich des Anschlußstutzens (39) wenigstens einmal durch einen Ferritkern (47) geführt ist.

8. Kombinationsinstrument nach einem der Ansprüche 1 bis 7, dadurch gekennzeichnet, daß auf wenigstens einer Außenfläche des hochfrequenzdichten Gehäuses das Unterteil (38) einer Mehrfach-Steckvorrichtung befestigt ist, und daß die elektrischen Kontakte durch langgestreckte Leiter (32) gebildet sind, die einstückig von der Leiterplatte (33) durch die Gehäusewand (34) in die Steckvorrichtung ragen.

9. Kombinationsinstrument nach Anspruch 8, dadurch gekennzeichnet, daß die langgestreckten Leiter Kontaktstifte sind, die mittels Durchführungskondensatoren (37) durch Durchbrüche (36) der Gehäusewand (34) geführt sind.

10. Kombinationsinstrument nach einem der Ansprüch 8 oder 9, dadurch gekennzeichnet, daß der langgestreckte Leiter (32) wenigstens einmal durch einen Ferritkern (48) geführt sind.

## Claims

1. Combined instrument unit for motor vehicles, wherein various indicating instruments, display panels, monitoring and warning lights, and possibly operating elements, and also electrical and electronic equipment parts, are arranged in a common housing and covered with a common window, characterised in that an indicating computer (36) is provided which is arranged in a further housing (31) which is substantially sealed against high frequencies, and that the housing sealed against high frequencies is arranged on a conductor plate (25).

2. Combined instrument unit according to claim 2, characterised in that the peripheral wiring of the computer unit (36) is also arranged in the housing (31) which is sealed against high frequencies.

3. Combined instrument unit according to claim 1 or 2, characterised in that connecting noses (37, 38, 39) are provided for leading-through the connecting lines (41, 43, 46) on the conductor plate (33) for the computer unit (36).

4. Combined instrument unit according to claim 3, characterised in that the housing cover (32) of the housing (31) sealed against high frequencies is shaped to form respective sheet metal covers (40) in each case surrounding one of the connecting noses (37, 38, 39).

5. Combined instrument unit according to claim 4, characterised in that the diameter and length of the sheet metal cover (40) and also the material of the connecting nose (37) are chosen in accordance with the desired capacitance of the capacitor formed of sheet metal cover (40) and led-through line (41).

6. Combined instrument unit according to one of the preceding claims, characterised in that the line (43) is led through the connecting nose (38) by means of a bushing capacitor (45).

7. Combined instrument unit according to one of claims 1 to 6, characterised in that the line (46) is guided at least once through a ferrite core (47) in the immediate vicinity of the connecting nose (39).

8. Combined instrument unit according to one of claims 1 to 7, characterised in that there is fixed to at least one outer surface of the housing sealed against high frequencies the lower part (38) of a multiple plug device, and that the electrical contacts are formed of elongated conductors (32) which project in one piece from the conductor plate (33) through the housing wall (34) into the plug device.

9. Combined instrument unit according to claim 8, characterised in that the elongated conductors are contact pins which are guided by means of a bushing-type capacitor (37) through openings (36) in the housing wall (34).

10. Combined instrument unit according to one of claims 8 or 9, characterised in that the elongated conductor (32) is guided at least once through a ferrite core (48).

## Revendications

1. Panneau d'instruments pour automobile, dans lequel un certain nombre d'instruments indicateurs, de plaques d'affichage, de voyants de contrôle et d'avertissement et éventuellement d'organes de manoeuvre, ainsi que des éléments d'équipement électriques et électroniques sont disposés dans un boîtier commun recouvert d'une glace commune, panneau caractérisé en ce qu'il comporte un ordinateur (36) de signalisation, qui est disposé dans un autre boîtier (31) sensiblement imperméable aux fréquences élevées, et en ce que ce boîtier imperméable aux fréquences élevées est disposé sur une plaque-pilote ou plaque de circuit(s) imprimé(s) (25).

2. Panneau d'instruments selon la revendication 1, caractérisé en ce que les conducteurs de connexion de la périphérie de l'ordinateur (36) sont également disposés dans le boîtier (31) imperméable aux fréquences élevées.

3. Panneau d'instruments selon la revendication 1 ou 2, caractérisé en ce qu'il comporte des manchons (37, 38, 39) de connexion, destinés à faire traverser la plaque-pilote (33) par les conducteurs (41, 43 ; 46) de connexion à l'ordinateur (36).

4. Panneau d'instruments selon la revendication 3, caractérisé en ce que l'enveloppe (32) du boîtier (31) insensible aux fréquences élevées est repoussée en formant des chemises (40) métalliques entourant chacun des manchons (37, 38, 39) de connexion.

5. Panneau d'instruments selon la revendication 4, caractérisé en ce que la longueur et le diamètre de la chemise (40) et la matière du manchon (37) de connexion sont déterminés en fonction de la capacité que doit avoir le condensateur formé par cette chemise (40) et par le conducteur (41) qui y passe.

6. Panneau d'instruments selon l'une des revendications précédentes, caractérisé en ce que le conducteur (43) sort du manchon (38) de connexion grâce à un condensateur (45) de traversée.

7. Panneau d'instruments selon l'une des revendications 1 à 6, caractérisé en ce que le conducteur (46) passe au moins une fois dans un noyau (47) de ferrite, à proximité immédiate du manchon (39) de connexion.

8. Panneau d'instruments selon l'une des revendications 1 à 7, caractérisé en ce que la partie inférieure (38) d'un connecteur multiple est fixée sur au moins une face extérieure du boîtier imperméable aux fréquences élevées et en ce que les contacts électriques sont formés par des conducteurs (32) continus très longs, qui partent de la plaque-pilote (33) jusqu'à ce connecteur en traversant la paroi (34) du boîtier.

9. Panneau d'instruments selon la revendication 8, caractérisé en ce que les conducteurs très longs sont des broches de contact qui passent, au moyen de condensateurs (37) de traversée, dans des ouvertures (36) de la paroi (34) du boîtier.

10. Panneau d'instruments selon l'une des revendications 8 ou 9, caractérisé en ce que les conducteurs (32) très longs passent au moins une fois dans un noyau (48) de ferrite.
